# EUROPÄISCHE PATENTSCHRIFT

(11) **EP 1 138 084 B1**
(45) Veröffentlichungstag und Bekanntmachung des Hinweises auf die Patenterteilung: **06.07.2005**
(21) Anmeldenummer: 99963195.5
(22) Anmeldetag: 03.11.1999
(51) Int. Cl.: H01L 29/78, H01L 29/51

(54) **FERROELEKTRISCHER TRANSISTOR UND VERFAHREN ZU DESSEN HERSTELLUNG**
FERROELECTRIC TRANSISTOR AND METHOD FOR THE PRODUCTION THEREOF
TRANSISTOR FERROELECTRIQUE ET SON PROCEDE DE PRODUCTION

(30) Priorität: 04.11.1998 DE 19850852
(43) Veröffentlichungstag der Anmeldung: 04.10.2001
(73) Patentinhaber: Infineon Technologies AG, 81669 München (DE)
(72) Erfinder: HANEDER, Thomas-Peter, D-81549 München (DE); WILLER, Josef, D-85521 Riemerling (DE); BRAUN, Georg, D-80339 München (DE); SCHLÖSSER, Till, D-81825 München (DE)
(74) Vertreter: Wilhelm, Jürgen, Dipl.-Phys.
(86) Internationale Anmeldenummer: PCT/DE1999/003514
(87) Internationale Veröffentlichungsnummer: WO 2000/026969

(56) Entgegenhaltungen:
- EP-A- 0 869 557
- GB-A- 2 299 208
- US-A- 5 940 705

## Beschreibung

Die Erfindung betrifft einen ferroelektrischen Transistor, der zwei Source-/Drain-Gebiete, einen Kanalbereich und eine Gateelektrode aufweist, wobei zwischen der Gateelektrode und dem Kanalbereich eine Schicht aus ferroelektrischem Material vorgesehen ist. Die Änderung der Leitfahigkeit dieses Transistors ist von dem Polarisationszustand der Schicht aus ferroelektrischem Material abhängig. Derartige ferroelektrische Transistoren werden im Hinblick auf nichtflüchtige Speicher untersucht. Dabei werden zwei verschiedenen logischen Werten einer digitalen Information zwei verschiedene Polarisationszustände der Schicht aus ferroelektrischem Material zugeordnet. Weitere Einsatzmoglichkeiten für derartige ferroelektrische Transistoren sind zum Beispiel neuronale Netze.

Bei diesen ferroelektrischen Transistoren tritt das Problem auf, daß ferroelektrisches Material, das an der Oberfläche eines Halbleitersubstrats angeordnet ist, schlechte Grenzflacheneigenschaften zeigt. Ferner treten Diffusionsprozesse zwischen einzelnen Bestandteilen des ferroelektrischen Materials und dem Halbleitersubstrat auf. Um den Einfluß dieser Effekte auf die elektrischen Eigenschaften eines ferroelektrischen Transistors zur reduzieren, ist vorgeschlagen worden, zwischen der ferroelektrischen Schicht und dem Halbleitersubstrat eine Zwischenschicht aus SiO₂ (siehe EP 0 566 585 B1) oder aus CeO₂, Y₂O₃ oder ZrO₂ (siehe zum Beispiel T. Hirai et al, Jpn. J. Appl. Phys. Vol. 36 (1997) Seiten 5908 bis 5911 oder H. Nyung Lee et al, Ext. Abst. Int. Conf. SSDM, Hamamatsu, 1997, Seiten 382 bis 383) zu verwenden. Diese Materialien sind isolierende stabile Oxide, die eine ausreichend gute Grenzfläche zwischen der ferroelektrischen Schicht und der Oberfläche des Halbleitersubstrats sicherstellen.

In dem ferroelektrischen Transistor wirkt die Zwischenschicht als zusätzliche Kapazität, die beim Anlegen einer Spannung zwischen der Gateelektrode und dem Halbleitersubtrat den über die ferroelektrische Schicht abfallenden Teil der Spannung reduziert. Dadurch wird der Durchgriff einer an der Gateelektrode anliegenden Spannung auf das Kanalgebiet verschlechtert. Beim Speichern von Information in dem ferroelektrischen Transistor durch das Anlegen einer ausreichend großen Spannung an die ferroelektrische Schicht, so daß die Polarisation des ferroelektrischen Materials verandert wird, fällt dadurch nur ein Teil der angelegten Spannung über der ferroelektrischen Schicht ab.

Weitere Bautelemente sind in EP869557, JP10209389 und GB2299208 beschrieben.

Der Erfindung liegt daher das Problem zugrunde, einen ferroelektrischen Transistor und ein Verfahren zu dessen Herstellung anzugeben, bei dem der Durchgriff einer an der Gateelektrode anliegenden Spannung gegenüber bekannten Lösungen ohne Verschlechterung der Grenzflachen verbessert ist.

Dieses Problem wird erfindungsgemäß gelöst durch einen ferroelektrischen Transistor gemäß Anspruch 1 sowie durch ein Verfahren zu dessen Herstellung gemaß Anspruch 8. Weitere Ausgestaltungen der Erfindung gehen aus den übrigen Ansprüchen hervor.

Der ferroelektrische Transistor weist in einem Halbleitersubstrat zwei Source-/Drain-Gebiete und einen dazwischen angeordneten Kanalbereich auf. An der Oberfläche des Kanalbereichs ist eine metallische Zwischenschicht angeordnet, die mit dem Halbleitersubstrat eine Schottky-Diode bildet. An der Oberfläche der metallischen Zwischenschicht ist eine ferroelektrische Schicht angeordnet, an deren Oberflache eine Gateelektrode angeordnet ist. Der ferroelektrische Transistor weist somit die Struktur eines MESFET auf, dessen Gateelektrode durch einen ferroelektrischen Isolator vom eigentlichen Metallhalbleiterkontakt getrennt ist.

Die Speicherzelle kann zum Beispiel wie folgt betrieben werden: Zum Auslesen der Information wird an die Gateelektrode des Transistors ein kurzer Spannungspuls (zum Beispiel einige ns) der Richtung angelegt, daß der Schottky-Kontakt in Sperrichtung betrieben wird. Dieser Spannungsimpuls wird in Größe und Dauer so gewählt, daß er ausreicht, um die ferroelektrische Schicht umzupolarisieren (Dauer in der Größenordnung ns), andererseits aber nicht ausreicht, um durch den in Sperrichtung betriebenen Schottky-Kontakt die dem Umpolarisationsvorgang entsprechende Ladung ΔQ oder die dem dielektrischen Anteil entsprechende Ladung Q fließen zu lassen.

Dadurch kann erreicht werden, daß wahrend der Pulsdauer ein Teil der an der Gateelektrode anliegenden Spannung über dem Schottky-Kontakt abfallt.

Beim Anliegen eines Spannungspulses sind zwei Fälle zu entscheiden:
1. Ist die Polarisationsrichtung der ferroelektrischen Schicht zu Beginn des Spannungspulses derart, daß sie durch den Spannungspuls umgedreht wird, so wird die Spannung zwischen der Gateelektrode und dem Halbleiter zunachst abfallen - nämlich für die Dauer des Umpolarisationsvorgangs - und erst danach konstant sein.
2. Ist die ferroelektrische Schicht dagegen schon zu Beginn des Spannungspulses an der Gateelektrode in Richtung dieser Spannung polarisiert, dann verhalt sich die ferroelektrische Schicht ähnlich wie eine rein dielektrische Schicht, das heißt die während der Pulsdauer Δt zwischen der Gateelektrode und dem Halbleiter abfallende Spannung ist konstant.

Wird die Dotierung im Kanalbereich des Transistors entsprechend gewählt, so ist es möglich mit dem über dem Schottky-Kontakt abfallenden Teil der Spannung an der Gateelektrode den Transistor zu steuern, das heißt den Transistor ein- oder auszuschalten, je nachdem ob es sich dabei um einen normally off (selbstsperrenden) oder einen normally on selbstleitenden) Transistor handelt.

Die Ladungsmenge, die während der Pulsdauer durch den Kanal des Transistors fließt, wird also bei einem normally off Transistor im Fall 1 geringer sein als im Fall 2. Für einen normally on Transistor gilt das Umgekehrte. Durch Aufintegration dieser Ladungsmenge während der Pulsdauer ist es möglich, die gespeicherte Information zu bewerten.

Wurde durch den Auslesevorgang die eingeschriebene Information zerstört (Fall 1), so muß sie anschließend wieder in die Zelle eingeschrieben werden.

Das Einschreiben oder Löschen von Information in eine Zelle kann durch eine größere Spannung zwischen der Gateleketrode und dem Halbleiter erfolgen als das Auslesen der Information, was größere Ströme durch den Schottky-Kontakt (sowohl in Durchlaß- als auch in Sperrichtung) der Anordnung hervorruft, so daß die darüber abfallende Spannung nach kurzer Zeit zu Null wird und die gesamte Spannung zwischen Elektrode und Halbleiter bzw. Metallschicht (Halbleiter und Metallschicht besitzen daselbe Potential) über der ferroelektrischen Schicht abfällt.

Alternativ kann das Einschreiben oder Löschen von Information auch auf einer anderen, längeren Zeitskala als das Auslesen erfolgen, so daß während längerer Pulsdauern mehr Ladung durch den Schottky-Kontakt fließen kann und deswegen nach kurzer Zeit (zum Beispiel einige 10 ns) auch in diesem Fall keine Spannung mehr am Schottky-Kontakt abfällt.

Weitere Betriebsweisen der Speicherzelle sind möglich.

In diesem ferroelektrischen Transistor entfallt somit sowohl beim Einspeichern von Information als auch beim Löschen von Information die in den bekannten ferroelektrischen Transistoren vorhandene zusatzliche Kapazitat zwischen Halbleitersubstrat und ferroelektrischer Schicht. Gleichzeitig wird ein direkter Kontakt zwischen der ferroelektrischen Schicht und der Halbleiteroberfläche vermieden.

Es liegt im Rahmen der Erfindung, die metallische Zwischenschicht aus Pt, WSi₂, Au oder Ti vorzusehen. Die Verwendung von WSi₂ hat den Vorteil, daß WSi₂ mit guten Grenzflacheneigenschaften auf der Oberfläche eines Halbleitersubstrats erzeugt werden kann.

Die Oberfläche des Kanalbereichs schließt mit der Oberfläche des Halbleitersubstrats ab, während die Oberfläche der Source-/Drain-Gebiete unterhalb der Oberfläche des Halbleitersubstrats angeordnet ist. Dadurch wird ein Kurzschluß zwischen den Source-/Drain-Gebieten über die metallische Zwischenschicht vermieden.

Alternativ kann ein derartiger Kurzschluß auch dadurch verhindert werden, daß die Source-/Drain-Gebiete ein laterales Dotierungsprofil aufweisen, so daß sie im Überlappungsbereich mit der metallischen Zwischenschicht einen Schottky-Kontakt bilden.

Die Verwendung von Platin für die metallische Zwischenschicht hat den Vorteil, daß viele ferroelektrische Materialien sehr gut für die Abscheidung auf Platin geeignet sind. Im Zusammenhang mit der Entwicklung von ferroelektrischen Kondensatoren werden derartige Abscheideverfahren untersucht und optimiert.

Vorzugsweise wird die Zwischenschicht aus zwei Teilschichten zusammengesetzt, wobei eine erste Teilschicht, die der Oberflache des Kanalbereichs benachbart ist, aus WSi₂ und eine zweite Teilschicht, die an die ferroelektrische Schicht angrenzt, aus Platin gebildet wird. Dadurch werden gleichzeitig eine gute Grenzfläche zum Halbleitersubstrat und gute Abscheidebedingungen für die ferroelektrische Schicht erzielt.

Für die ferroelektrische Schicht sind alle ferroelektrischen Materialien geeignet. Insbesondere weist die ferroelektrische Schicht Strontium-Wismut-Tantalat (SBT), Blei-Zirkonium-Titanat (PZT), Lithium-Niobat (LiNbO₃) oder Barium-Strontium-Titanat (BST) auf.

Im Hinblick auf die Spannungsfestigkeit des ferroelektrischen Transistors ist es vorteilhaft, die metallische Zwischenschicht, die ferroelektrische Schicht und die Gateelektrode mit gemeinsamen Flanken vorzusehen, die mit isolierenden Spacern versehen sind. Dabei ist es vorteilhaft, die isolierenden Spacer aus ferroelektrischem Material zu bilden, da dadurch eine Beeinträchtigung der Eigenschaften der ferroelektrischen Schicht durch eine Grenzfläche zu einem anderen Material vermieden wird.

Vorzugsweise erfolgt die Herstellung eines solchen ferroelektrischen Transistors innerhalb einer Siliziumprozeßtechnologie. Als Halbleitersubstrat ist insbesondere eine monokristalline Siliziumscheibe, ein SOI-Substrat oder ein SIC-Substrat geeignet.

Ferner ist als Halbleitersubstrat ein III-V-Halbleitersubstrat, zum Beispiel ein GaAs-Substrat, insbesondere aus semiisolierendem GaAs geeignet. Da in semiisolierenden GaAs-Substrat vielfach MESFETs realisiert werden, ist die Speicherzelle in diese Technologie gut integrierbar.

Zur Herstellung des ferroelektrischen Transistors werden durch Abscheidung und Strukturierung eine metallische Zwischenschicht, die mit dem Halbleitersubstrat eine Schottky-Diode bildet, eine ferroelektrische Schicht und eine Gateelektrode gebildet. Auf zwei einander gegenüberliegenden Seiten der Gateelektrode in dem Halbleitersubstrat werden Source-/Drain-Gebiete gebildet. Die Strukturierung der metallischen Zwischenschicht kann sowohl durch Lift-off-Technik als auch durch Ätztechnik erfolgen. Die ferroelektrische Schicht kann durch ein ein- oder mehrstufiges Sol-Gel-Verfahren oder durch Abscheidung in einem CVD-Prozeß und anschließende Temperung gebildet werden.

Im folgenden wird die Erfindung anhand eines Ausführungsbeispiels, das in den Figuren dargestellt ist, naher erläutert.
- Figur 1: zeigt einen Schnitt durch einen ferroelektrischen Transistor, der zwischen einem Kanalbereich und einer ferroelektrischen Schicht eine metallische Zwischenschicht aufweist.
- Figur 2: zeigt ein Halbleitersubstrat nach Bildung einer metallischen Zwischenschicht und einer ferroelektrischen Schicht.
- Figur 3: zeigt das Halbleitersubstrat nach Bildung einer Gateelektrode.

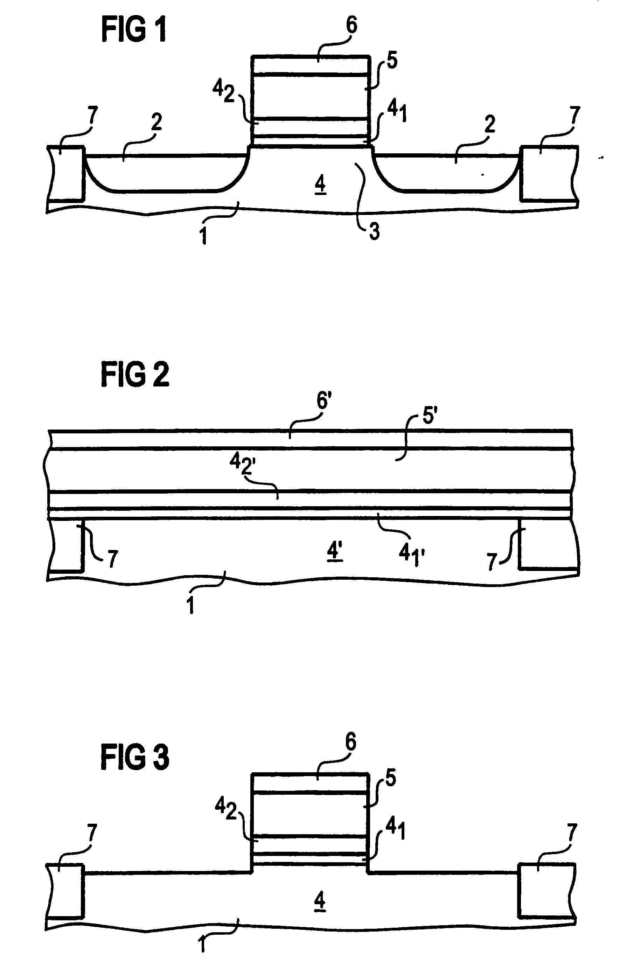

In einem p-dotierten Halbleitersubstrat 1 aus monokristallinem Silizium sind zwei Source-/Drain-Gebiete 2 angeordnet (siehe Figur 1). Zwischen den Source-/Drain-Gebieten 2 ist ein Kanalbereich 3 angeordnet. Die Source-/Drain-Gebiete 2 sind n-dotiert und weisen eine Dotierstoffkonzentration von ca. 10¹⁹ cm⁻³ bis 10²⁰ cm⁻³ auf.

An der Oberflache des Kanalbereichs 3 ist eine metallische Zwischenschicht 4 angeordnet, die eine 30 bis 50 nm dicke WSi₂-Schicht 4₁ und eine 100 nm dicke Platinschicht 4₂ umfaßt. Die WSi₂-Schicht 4₁ grenzt dabei an die Oberfläche des Halbleitersubstrats 1 an. Die Platinschicht 4₂ ist oberhalb der WSi₂-Schicht 4₁ angeordnet.

An der Oberfläche der Platinschicht 4₂ ist eine ferroelektrische Schicht 5 aus Strontium-Wismut-Tantalat (SBT) oder Blei-Zirkonium-Titanat (PZT) angeordnet. Die ferroelektrische Schicht 5 weist eine Dicke von 100 nm auf.

An der Oberflache der ferroelektrischen Schicht 5 ist eine Gateelektrode 6 angeordnet. Die Gateelektrode 6 enthält Platin und weist eine Dicke von 100 nm auf.

Die Gateelektrode 6, die ferroelektrische Schicht 5 und die metallische Zwischenschicht 4 weisen gemeinsame Flanken auf, die auf die Oberfläche des Halbleitersubstrats 1 reichen. Der Kanalbereich 3 schließt mit der Oberfläche des Halbleitersubstrats 1 ab, während die Oberfläche der Source-/Drain-Gebiete 2 unterhalb der Oberfläche des Halbleitersubstrats 1 angeordnet ist. Dadurch wird vermieden, daß die Source-/Drain-Gebiete 2 über die metallische Zwischenschicht 4 kurzgeschlossen werden.

Die Source-/Drain-Gebiete 2 werden im Halbleitersubstrat 1 gegen benachbarte Bauelemente durch eine Isolationsstruktur 7 isoliert. Die Isolationsstruktur 7 umgibt ein aktives Gebiet für den ferroelektrischen Transistor ringförmig. Die Isolationsstrukturen 7 werden durch mit SiO₂ gefüllte flache Gräben realisiert.

Zur Herstellung des anhand von Figur 1 erläuterten ferroelektrischen Transistors werden in dem Halbleitersubstrat 1 zunächst die Isolationsstrukturen 7 gebildet. Dazu wird ein isolierender Graben geätzt, der das aktive Gebiet im ferroelektrischen Transistor vollstandig umgibt, und mit isolierendem Material aufgefüllt (siehe Figur 2). Alternativ konnen die Isolationsstrukturen 7 durch lokale Oxidation in einem LOCOS-Verfahren gebildet werden.

Anschließend wird auf die Oberflache des Halbleitersubstrats 1 zur Bildung der WSi₂-Schicht 4₁, der Platinschicht 4₂, der ferroelektrischen Schicht 5 und der Gateelektrode 6 eine ganzflächige WSi₂-Schicht 4₁', eine ganzflächige Platinschicht 4₂', eine ganzflächige ferroelektrische Schicht 5'und eine weitere ganzflächige Platinschicht 6' aufgebracht. Die ganzflächige WSi₂-Schicht 4₁' wird durch CVD, die ganzflächige Platinschicht 4₂' und die weitere ganzflächige Platinschicht 6' werden durch Sputtern oder CVD gebildet. Die ganzflachige ferroelektrische Schicht 6' wird in einem ein- oder mehrstufigen Sol-Gel-Verfahren oder durch CVD-Abscheidung und anschließende Temperung bei 500°C bis 800°C gebildet. Bei der anschließenden Temperung wird die gewunschte ferroelektrische Phase in der ferroelektrischen Schicht erzeugt. Diese Schichten 4₁', 4₂', 5', 6' werden anschließend mit einer gemeinsamen Maske (nicht dargestellt) strukturiert (siehe Figur 3). Dabei wird zunächst die Gateelektrode 6 aus der weiteren ganzflächigen Platinschicht 6' durch Ätzen mit Cl, Ar oder einer Mischung daraus gebildet. Die Platinschicht 4₂ und die WSi₂-Schicht 4₁ werden durch Ätzen mit Cl, Ar bzw. CF₄ hergestellt. Dabei wird die Gateelektrode 6 mit Lack geschützt. Die Ätzung wird soweit überzogen, daß die Oberflache des Halbleitersubstrats 1 seitlich der Gatelektrode 6 um 5 bis 20 nm zurückgeätzt wird.

Durch Implantation mit As werden die Source-/Drain-Gebiete 2 selbstjustiert zu der Isolationsstruktur 7 gebildet. Es ergibt sich die in Figur 1 dargestellte Struktur.

Alternativ kann die Gateelektrode 6 aus dotiertem Polysilizium gebildet werden. In diesem Fall ist es zweckmäßig, zwischen der Gateelektrode 6 und der ferroelektrischen Schicht 5 eine Barriereschicht zum Beispiel aus TiN vorzusehen.

Falls technologisch erforderlich, können die Flanken der Gateelektrode 6, der ferroelektrischen Schicht 5 und der metallischen Zwischenschicht 4 mit isolierenden Spacern insbesondere aus demselben ferroelektrischen Material wie die ferroelektrische Schicht 5 versehen sein.

Die isolierenden Spacer werden vorzugsweise aus demselben Material wie die ferroelektrische Schicht 5 gebildet, da dadurch eine Beeintrachtigung der Eigenschaften der ferroelektrischen Schicht 5, die bei Verwendung isolierender Spacer aus einem anderen Material verursacht werden kann, vermieden wird.

Ferner kann zwischen den Source-/Drain-Gebieten 2 und dem Kanalbereich 3 jeweils ein LDD-Gebiet (lightly doped drain) angeordnet sein, das eine geringere Dotierstoffkonzentration als die Source-/Drain-Gebiete 2 und eine geringere senkrechte Ausdehnung als die Source-/Drain-Gebiete 2 aufweist. Die LDD-Gebiete werden mit einer Dotierstoffkonzentration von zum Beispiel 10¹⁸ cm⁻³ gebildet.

## Patentansprüche

1. Ferroelektrischer Transistor,
- bei dem in einem Halbleitersubstrat (1) zwei Source-/Drain-Gebiete (2) und ein dazwischen angeordneter Kanalbereich (3) vorgesehen sind,
- bei dem an der Oberfläche des Kanalbereichs (3) eine metallische Zwischenschicht (4) angeordnet ist, die mit dem Halbleitersubstrat (1) eine Schottky-Diode bildet,
- bei dem an der Oberfläche der metallischen Zwischenschicht (4) eine ferroelektrische Schicht (5) angeordnet ist, und
- bei dem an der Oberfläche der ferroelektrischen Schicht (5) eine Gateelektrode (6) angeordnet ist,
- bei dem die Oberfläche des Kanalbereichs (3) mit der Oberfläche des Halbleitersubstrats abschließt, **dadurch gekennzeichnet, daß** die Oberfläche der Source-/Drain-Gebiete (2) unterhalb der Oberfläche des Halbleitersubstrats (1) angeordnet ist.

2. Ferroelektrischer Transistor nach Anspruch 1,
bei dem die metallische Zwischenschicht (4) mindestens eines der Materialien Pt, WSi₂, Au oder Ti enthält.

3. Ferroelektrischer Transistor nach Anspruch 2,
bei dem die metallische Zwischenschicht (4) mindestens im Bereich der Grenzfläche zu der ferroelektrischen Schicht (5) Platin aufweist.

4. Ferroelektrischer Transistor nach einem der Ansprüche 1 bis 3,
bei dem die metallische Zwischenschicht (4), die ferroelektrische Schicht (5) und die Gateelektrode (6) gemeinsame Flanken aufweisen, die mit isolierenden Spacern versehen sind.

5. Ferroelektrischer Transistor nach Anspruch 4,
bei dem die isolierenden Spacer ferroelektrisches Material enthalten.

6. Ferroelektrischer Transistor nach einem der Ansprüche 1 bis 5,
bei dem die ferroelektrische Schicht (5) Strontium-Wismut-Tantalat (SBT), Blei-Zirkon-Titanat (PZT), Lithium-Niobat (LiNbO₃) oder Barium-Strontium-Titanat (BST) enthält.

7. Ferroelektrischer Transistor nach einem der Ansprüche 1 bis 6,
- bei dem die Gateelektrode (6) Platin oder dotiertes Polysilizium enthält, und
- bei dem das Halbleitersubstrat (1) Silizium enthält.

8. Verfahren zur Herstellung eines ferroelektrischen Transistors
- bei dem auf einem Halbleitersubstrat (1) durch Abscheidung und Strukturierung eine metallische Zwischenschicht (4), die mit dem Halbleitersubstrat (1) eine Schottky-Diode bildet, eine ferroelektrische Schicht (5) und eine Gateelektrode (6) gebildet werden, und
- bei dem auf zwei einander gegenüberliegenden Seiten der Gateelektrode (6) in dem Halbleitersubstrat (1) Source-/Drain-Gebiete (2) gebildet werden,
- bei dem die Oberfläche des Kanalbereichs (3) so ausgestaltet wird, daß sie mit der Oberfläche des Halbleitersubstrats abschließt, **dadurch gekennzeichnet, daß** die Oberfläche der Source-/Drain-Gebiete (2) so ausgebildet wird, daß sie unterhalb der Oberfläche des Halbleitersubstrats (1) angeordnet ist.

9. Verfahren nach Anspruch 8,
- bei dem die metallische Zwischenschicht (4), die ferroelektrische Schicht (5) und die Gateelektrode (6) mit gemeinsamen Flanken gebildet werden,
- bei dem an den Flanken isolierende Spacer (8) gebildet werden.

10. Verfahren nach Anspruch 9,
bei dem die Source-/Drain-Gebiete (2) mit einem LDD-Profil gebildet werden.

## Claims

1. Ferroelectric transistor,
- in which two source/drain regions (2) and a channel region (3) arranged in between are provided in a semiconductor substrate (1),
- in which a metallic intermediate layer (4) is arranged on the surface of the channel region (3) and forms a Schottky diode with the semiconductor substrate (1),
- in which a ferroelectric layer (5) is arranged on the surface of the metallic intermediate layer (4), and
- in which a gate electrode (6) is arranged on the surface of the ferroelectric layer (5),
- in which the surface of the channel region (3) terminates with the surface of the semiconductor substrate, **characterized in that** the surface of the source/drain regions (2) is arranged below the surface of the semiconductor substrate (1).

2. Ferroelectric transistor according to Claim 1,
in which the metallic intermediate layer (4) contains at least one of the materials Pt, WSi₂, Au or Ti.

3. Ferroelectric transistor according to Claim 2,
in which the metallic intermediate layer (4) has platinum at least in the region of the interface with the ferroelectric layer (5).

4. Ferroelectric transistor according to one of Claims 1 to 3,
in which the metallic intermediate layer (4), the ferroelectric layer (5) and the gate electrode (6) have common sidewalls provided with insulating spacers.

5. Ferroelectric transistor according to Claim 4,
in which the insulating spacers contain ferroelectric material.

6. Ferroelectric transistor according to one of Claims 1 to 5,
in which the ferroelectric layer (5) contains strontium bismuth tantalate (SBT), lead zirconium titanate (PZT), lithium niobate (LiNbO₃) or barium strontium titanate (BST).

7. Ferroelectric transistor according to one of Claims 1 to 6,
- in which the gate electrode (6) contains platinum or doped polysilicon, and
- in which the semiconductor substrate (1) contains silicon.

8. Method for fabricating a ferroelectric transistor,
- in which a metallic intermediate layer (4) which forms a Schottky diode with the semiconductor substrate (1), a ferroelectric layer (5) and a gate electrode (6) are formed on a semiconductor substrate (1) by deposition and patterning, and
- in which source/drain regions (2) are formed in the semiconductor substrate (1) on two mutually opposite sides of the gate electrode (6),
- in which the surface of the channel region (3) is configured such that it terminates with the surface of the semiconductor substrate, **characterized in that** the surface of the source/drain regions (2) is designed such that it is arranged below the surface of the semiconductor substrate (1).

9. Method according to Claim 8,
- in which the metallic intermediate layer (4), the ferroelectric layer (5) and the gate electrode (6) are formed with common sidewalls,
- in which insulating spacers (8) are formed on the sidewalls.

10. Method according to Claim 9,
in which the source/drain regions (2) are formed with an LDD profile.

## Revendications

1. Transistor ferroélectrique,
- dans lequel deux zones source/drain (2) et une zone de canal (3) disposée entre les deux sont prévues dans un substrat semi-conducteur (1),
- dans lequel une couche intermédiaire métallique (4) est disposée au niveau de la surface de la zone de canal (3), ladite couche intermédiaire métallique formant une diode à barrière de Schottky avec le substrat semi-conducteur (1),
- dans lequel une couche ferroélectrique (5) est disposée au niveau de la surface de la couche intermédiaire métallique (4), et
- dans lequel une électrode de grille (6) est disposée au niveau de la surface de la couche ferroélectrique (5),
- dans lequel la surface de la zone de canal (3) se termine par la surface du substrat semi-conducteur,
**caractérisé en ce que** la surface des zones source/drain (2) est disposée en dessous de la surface du substrat semi-conducteur (1).

2. Transistor ferroélectrique selon la revendication 1, dans lequel la couche intermédiaire métallique (4) contient au moins un des matériaux suivants : Pt, WSi₂, Au ou Ti.

3. Transistor ferroélectrique selon la revendication 2, dans lequel la couche intermédiaire métallique (4) présente du platine au moins dans la zone de l'interface avec la couche ferroélectrique (5).

4. Transistor ferroélectrique selon l'une quelconque des revendications 1 à 3, dans lequel la couche intermédiaire métallique (4), la couche ferroélectrique (5) et l'électrode de grille (6) présentent des flancs communs qui sont munis d'entretoises isolantes.

5. Transistor ferroélectrique selon la revendication 4, dans lequel les entretoises isolantes contiennent du matériau ferroélectrique.

6. Transistor ferroélectrique selon l'une des revendications 1 à 5, dans lequel la couche ferroélectrique (5) contient du tantalate bismuth de strontium (SBT), du titanate zirconate de plomb (PZT), du niobate de lithium (LiNbO₃) ou du titanate de baryum et de strontium (BST).

7. Transistor ferroélectrique selon l'une des revendications 1 à 6,
- dans lequel l'électrode de grille (6) contient du platine ou du polysilicium dopé, et
- dans lequel le substrat semi-conducteur (1) contient du silicium.

8. Procédé de fabrication d'un transistor ferroélectrique
- dans lequel une couche intermédiaire métallique (4), qui forme une diode à barrière de Schottky avec le substrat semi-conducteur (1), une couche ferroélectrique (5) et une électrode de grille (6) sont formées sur un substrat semi-conducteur (1) par dépôt et structuration, et
- dans lequel des zones source/drain (2) sont formées sur deux faces opposées l'une à l'autre de l'électrode de grille (6) dans le substrat semi-conducteur (1),
- dans lequel la surface de la zone de canal (3) est formée de manière à ce qu'elle se termine par la surface du substrat semi-conducteur, **caractérisé en ce que** la surface des zones source/drain (2) est réalisée de manière à ce qu'elle soit disposée en dessous de la surface du substrat semi-conducteur (1).

9. Procédé selon la revendication 8,
- dans lequel la couche intermédiaire métallique (4), la couche ferroélectrique (5) et l'électrode de grille (6) sont formées avec des flancs communs,
- dans lequel des entretoises isolantes (8) sont formées au niveau des flancs.

10. Procédé selon la revendication 9, dans lequel les zones source/drain (2) sont formées avec un profil LDD.
